# EUROPÄISCHE PATENTSCHRIFT

(11) **EP 3 080 055 B1**
(45) Veröffentlichungstag und Bekanntmachung des Hinweises auf die Patenterteilung: **28.11.2018**
(21) Anmeldenummer: 14830502.2
(22) Anmeldetag: 28.11.2014
(51) Int. Cl.: C04B 37/02, C04B 35/645, H01L 23/15, H01L 21/48, H05K 1/03, H05K 3/38, H01L 23/373, H05K 3/02

(54) **VERFAHREN ZUM HERSTELLEN EINES METALL-KERAMIK-SUBSTRATES**
PROCESS FOR MANUFACTURING A METAL-CERAMIC SUBSTRATE
PROCÉDÉ DE FABRICATION D'UN SUBSTRAT MÉTAL-CÉRAMIQUE

(30) Priorität: 10.12.2013 DE 102013113734
(43) Veröffentlichungstag der Anmeldung: 19.10.2016
(73) Patentinhaber: Rogers Germany GmbH, 92676 Eschenbach (DE)
(72) Erfinder: MEYER, Andreas, 93173 Wenzenbach (DE); HIERSTETTER, Fabian, 92281 Kürmreuth (DE)
(74) Vertreter: Müller Schupfner & Partner Patent- und Rechtsanwaltspartnerschaft mbB
(86) Internationale Anmeldenummer: PCT/DE2014/100420
(87) Internationale Veröffentlichungsnummer: WO 2015/085991

(56) Entgegenhaltungen:
- WO-A1-2006/005281
- WO-A1-2013/120486
- DE-T5-112010 004 589
- US-A- 4 325 183
- US-A- 4 763 828
- US-A1- 2004 016 792

## Beschreibung

Die Erfindung betrifft ein Verfahren zum Herstellen eines Metall-Keramik-Substrates gemäß dem Oberbegriff des Patentanspruches 1 und 13.

Metall-Keramik-Substrate in Form von Leiterplatten bestehend aus einer Keramikschicht und wenigstens einer mit einer Oberflächenseite der Keramikschicht verbundenen und zur Ausbildung von Leiterbahnen, Kontakten, Kontakt- oder Anschlussflächen strukturierten Metallisierung sind in verschiedensten Ausführungen bekannt. Derartige Metall-Keramik-Substrate finden beispielsweise Verwendung zum Aufbau von Leistungshalbleiter-Modulen, d.h. sind für höhere Betriebsspannungen, und zwar 600 V und mehr bestimmt. Eine der Anforderungen an derartige Leistungshalbleiter-Module ist eine ausreichend hohe Teilentladungsfestigkeit, wobei auch Metall-Keramik-Substrate dieser Anforderung genügen müssen.

Zum Verbinden von die Metallisierung bildenden Metallfolien oder Metallschichten miteinander oder mit einem Keramiksubstrat bzw. einer Keramikschicht ist ferner das sogenannte "DCB-Verfahren" ("Direct-Copper-Bonding") bekannt. Dabei werden Metallschichten, vorzugsweise Kupferschichten oder -folien miteinander und/oder mit einer Keramikschicht verbunden, und zwar unter Verwendung von Metall- bzw. Kupferblechen oder Metall- bzw. Kupferfolien, die an ihren Oberflächenseiten eine Schicht oder einen Überzug ("Aufschmelzschicht") aus einer chemischen Verbindung aus dem Metall und einem reaktiven Gas, bevorzugt Sauerstoff aufweisen. Bei diesem beispielsweise in der US-PS 37 44 120 oder in der DE-PS 23 19 854 beschriebenen Verfahren bildet diese Schicht oder dieser Überzug ("Aufschmelzschicht") ein Eutektikum mit einer Schmelztemperatur unter der Schmelztemperatur des Metalls (z.B. Kupfers), so dass durch Auflegen der Metall- bzw. Kupferfolie auf die Keramikschicht und durch Erhitzen sämtlicher Schichten diese miteinander verbunden werden können, und zwar durch Aufschmelzen der Metallschicht bzw. Kupferschicht im Wesentlichen nur im Bereich der Aufschmelzschicht bzw. Oxidschicht. Ein derartiges DCB-Verfahren weist dann beispielsweise folgende Verfahrensschritte auf:
- Oxidieren einer Kupferfolie derart, dass sich eine gleichmäßige Kupferoxidschicht ergibt;
- Auflegen der Kupferfolie mit der gleichmäßigen Kupferoxidschicht auf die Keramikschicht;
- Erhitzen des Verbundes auf eine Prozesstemperatur zwischen etwa 1025 bis 1083°C, beispielsweise auf ca. 1071 °C;
- Abkühlen auf Raumtemperatur.

Ein Nachteil des DCB-Verfahrens besteht darin, dass prozessbedingte Fehlstellen zwischen der jeweiligen Kupferschicht und der Keramikschicht auftreten können. Diese Fehlstellen beeinträchtigen zwar die thermischen Eigenschaften eines unter Verwendung des DCB-Verfahrens hergestellten Metall-Keramik-Substrates kaum, jedoch ergibt sich aufgrund der Fehlstellen eine Verschlechterung der Teilentladungsfestigkeit des daraus hergestellten Leistungshalbleiter-Moduls.

Ferner ist aus den Druckschriften DE 22 13 115 und EP-A-153 618 das so genannte Aktivlot-Verfahren zum Verbinden von Metallisierungen bildenden Metallschichten oder Metallfolien, insbesondere auch von Kupferschichten oder Kupferfolien mit einem Keramikmaterial bzw. einer Keramikschicht bekannt. Bei diesem Verfahren, welches speziell auch zum Herstellen von Metall-Keramik-Substraten verwendet wird, wird bei einer Temperatur zwischen ca. 800 - 1000°C eine Verbindung zwischen einer Metallfolie, beispielsweise Kupferfolie, und einem Keramiksubstrat, beispielsweise einer Aluminiumnitrid-Keramik, unter Verwendung eines Hartlots hergestellt, welches zusätzlich zu einer Hauptkomponente, wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch eine chemische Reaktion eine Verbindung zwischen dem Hartlot und der Keramik her, während die Verbindung zwischen dem Hartlot und dem Metall eine metallische Hartlöt-Verbindung ist. Nachteilig ist jedoch das erforderliche Hartlot sehr kostenintensiv und die Strukturierung der mittels eines Aktivlot-Verfahrens aufgebrachten Metallisierung prozesstechnisch aufwendig.

Aus der EP 1 716 624 B1 ist bereits ein Verfahren zum Herstellen eines Stapels aus mehreren Metallplatten zur Bildung eines Kühlers zu entnehmen, bei dem mehrere dünne Metallplatten bzw. Metallfolien miteinander zu einem Stapel verbunden werden, welche dann einen Kühler, insbesondere einen Mikrokühler bilden. Zur Vermeidung des Entstehens von Mikrolunkern in den Übergangsbereiches zwischen den Metallplatten findet eine Nachbehandlung des Plattenstapels in einer Schutzgasatmosphäre bei einer hohen Behandlungstemperatur unterhalb der Fügetemperatur und bei einem hohen Gasdruck im Bereich zwischen 200 und 2000 bar statt. Diese Nachbehandlung wird auch als heißisostatisches Pressen ("HIP-Verfahren") bezeichnet. Das Beaufschlagung des Plattenstapels mit hohem Gasdruck in der Schutzgasatmosphäre bei den genannten Temperaturbedingungen führt u.a. dazu, dass die Verbindung zwischen den Platten weitestgehend frei von Mikrolunkern ist, d.h. Ausnehmungen oder Hohlräumen im Verbindungsbereich zweier Metallplatten nicht bestehen. Als Schutzgas finden hierbei Stickstoff, Argon oder andere Inert- oder Edelgase Anwendung. Die Behandlungstemperatur ist derart eingestellt, dass eine Diffusionsschweißverbindung zwischen den aneinander anschließenden Oberflächen der Metallplatten entsteht.

Aus der EP 1 774 841 B1 ist ein Verfahren zum Herstellen eines Metall-Keramik-Substrates bekannt, bei dem auf mindestens einer Oberflächenseite einer Keramikschicht eine Kupferschicht unter Verwendung des DCB-Verfahrens aufgebracht wird. Hierbei wird in einem nachfolgenden Verfahrensschritt das Metall-Keramik-Substrat einem Gasdruck im Bereich von 400 - 2000 bar unterzogen und bei einer Nachbehandlungstemperatur im Bereich zwischen 450 und 1060°C nachbehandelt. Zur Vermeidung von Fehlstellen bzw. Mikrolunkern im Bereich des Metall-Keramik-Überganges nach dem DCB-Prozess wird das Substrat in einem geschlossenen Druckraum in einer Schutzgasatmosphäre, beispielsweise Argonatmosphäre durch Erhitzen auf eine Temperatur von etwa 560°C bei einem Druck von etwa 1100 bar der beschriebenen Nachbehandlung unterzogen. Hierdurch wird die Anbindung der Kupfermetallisierungen an die Keramikschicht erhöht und das Entstehen von Fehlstellen deutlich reduziert.

Nachteilig weisen die genannten Verfahren zur Behebung der Fehlstellen einen hohen prozesstechnischen Aufwand auf, zumal zunächst eine direkte flächige Fügeverbindung zwischen der Metallschicht und der Keramikschicht mittels einer ersten Verbindungstechnologie herzustellen ist und diese im Anschluss daran einer Nachbehandlung zu unterziehen ist, um die im Rahmen des Fügeprozesses entstandenen Mikrolunker zu beseitigen.

Auch ist aus der US 4,763,828 bereits ein Verfahren zur Herstellung einer direkten flächigen Verbindung einer Keramikschicht mit einer Metallschicht bekannt, bei dem unter Verwendung des HIP-Verfahrens eine Diffusionsschweiß-Verbindung in einer Argon-Schutzgasatmosphäre beschrieben wird.

Aus der WO 2012/048 071 A1 ist ein mehrschichtiges Mantelmaterial umfassend eine Keramikschicht und ein metallisches Material für Nuklearreaktoren bekannt. Aus diesem mehrschichtigen Mantelmaterial wird eine Röhre oder ein Kanal gebildet. Das metallische Material formt hierbei die "innere" Schicht der Röhre oder des Kanals und bewirkt eine hermetische Abdichtung dessen.

Ferner ist aus der US 4,325, 183 ein Verfahren zur Herstellung eines elektrischen Widerstandes umfassend einer mit einem Keramiksubstrat verbundenen Metallfolie bekannt, bei dem eine direkte flächige Verbindung zwischen der Metallfolie und dem Keramiksubstrat mittels des HIP-Prozesses hergestellt wird. Hierzu wird die Anordnung aus der Metallfolie und dem Keramiksubstrat in einer versiegelten Umhüllung aufgenommen, wobei die Umhüllung dicht anliegt und zuvor vakuumiert wurde.
WO 2013/120486 A1 zeigt ein Metall-Keramik Substrat umfassend eine Keramikschicht, die an beiden Oberflächen mit einer Metallisierung versehen ist, und beschreibt halbschalenartige Metallisierungen, die flanschartige Verbindungsbereiche ausbildende Randabschnitte aufweisen. Mittels Verschweißens oder Verklebens können diese verbunden werden, um eine dichte Metalleinhausung zu bilden. Diese Druckschrift erwähnt aber keine HIP-Behandlung.

Ausgehend von dem voranstehend genannten Stand der Technik liegt der Erfindung die Aufgabe zugrunde, ein Verfahren zur Herstellung eines Metall-Keramik-Substrates aufzuzeigen, welches eine lunkerfreie bzw. mikrolunkerfreie flächige und direkte Verbindung zwischen der Keramik- und Metallschicht ermöglicht, welches ressourcenschonend und mittels weniger Verfahrensschritte realisierbar ist. Die Aufgabe wird durch ein Verfahren gemäß dem Patentanspruch 1 und 13 gelöst.

Der wesentliche Aspekt des erfindungsgemäßen Verfahrens ist darin zu sehen, dass eine erste und zweite Metallschicht und die Keramikschicht übereinander gestapelt werden, und zwar derart, dass die freien Randabschnitte der ersten und zweiten Metallschicht jeweils randseitig über die Keramikschicht überstehen, dass zur Bildung eines gasdicht verschlossenen, einen Behälterinnenraum einschließenden Metallbehälters zur Aufnahme der Keramikschicht die ersten und zweiten Metallschichten im Bereich der überstehenden freien Randabschnitte zueinander verformt und direkt miteinander verbunden werden, dass die den Metallbehälter bildenden Metallschichten mit der im Behälterinneren aufgenommenen Keramikschicht in einer Behandlungskammer bei einem Gasdruck zwischen 500 und 2000 bar und einer Prozesstemperatur zwischen 300°C bis zur Schmelztemperatur der Metallschichten zur Herstellung einer Verbindung heißisostatisch miteinander verpresst werden, wobei zumindest die überstehenden, miteinander verbundenen freien Randabschnitte der Metallschicht nach dem heißisostatischen Verpressen der Metallschichten mit der Keramikschicht zur Bildung der ersten und zweiten Metallisierung entfernt werden. Besonders vorteilhaft werden die randseitig überlappenden Metallschichten zur gasdichten Kapselung der Keramikschicht für den nachfolgenden HIP-Prozess verwendet. Hierdurch ergibt sich ein besonders effizientes und ressourcenschonendes Verfahren zur direkten flächigen Verbindung einer Metallschicht mit einer Keramikschicht, und zwar frei von störenden Lunkern bzw. Mikrolunkern. Weiterhin vorteilhaft können unter Verwendung des HIP-Verfahrens im Vergleich zum DCB-Verfahren dünnere Metallschichten verarbeitet und auf eine Keramikschicht aufgebracht werden. Die Mindestdicke der mittels des DCB-Verfahrens verarbeitbaren Metallschichten beträgt ca. 200 Mikrometer, wohingegen bei Verwendung des HIP-Verfahrens bereits Metallschichten mit einer Schichtdicke von ca. 50 Mikrometer und mehr auf die Keramikschicht aufbringbar sind. Weiterhin vorteilhaft können die Korngrößen beim HIP-Verfahren im Vergleich zum DCB-Verfahren ebenfalls eingestellt werden.

Gemäß einer vorteilhaften Weiterbildung des erfindungsgemäßen Verfahrens werden zur Bildung des Metallbehälters die freien Randabschnitte der Metallschichten vor deren direkten Verbindung durch Beaufschlagen mit einer Spannkraft verformt und anschließend die die freien Randabschnitte der Metallschichten randseitig durch Schweißen, insbesondere Kontaktschweißen oder Laserschweißen oder durch Löten, auch Hartlöten miteinander verbunden. Alternativ kann die randseitige direkte Verbindung der Metallschichten mittels eines mechanischen Verbindungs- und/oder Bearbeitungsverfahren hergestellt werden und zwar durch Walzen, Verpressen und/oder Umbördeln der freien Randabschnitte.

Besonders vorteilhaft wird der Behälterinnenraum vor dem randseitigen direkten Verbinden der Metallschichten vakuumiert, wobei in den vakuumierten Behälterinnenraum vor dem randseitigen direkten Verbinden der Metallschichten zusätzlich Sauerstoff eingebracht werden kann. Durch das Vakuumieren und Einbringen von Sauerstoff bildet sich eine für den HIP-Prozess optimale Atmosphäre aus, insbesondere entsteht eine Oxidschicht auf der Keramikschicht und/oder Metallschicht, mittels der die Haftfestigkeit der Diffusionsverbindung zusätzlich erhöht wird.

Weiterhin vorteilhaft werden die Metallschichten im Vakuum oder in einer Inertgasatmosphäre, vorzugsweise unter Verwendung von Stickstoff oder Argons als Inertgas randseitig direkt miteinander verbunden.

Gemäß einer vorteilhaften Ausführungsvariante wird zusätzlich zu der Keramikschicht in den Behälterinnenraum ein poröses Material, insbesondere eine poröse Hilfskeramikschicht eingebracht, die zur Aufnahme eines im Behälterinnenraum vorhandenen Restgases ausgebildet ist. Damit können durch vorhandenes Restgases bei der Durchführung des HIP-Prozesses erzeugte Einschlüsse vermieden werden. Vorzugsweise wird das poröse Material vor dem Einbringen in den Behälterinnenraum vakuumiert und mit einer gasdichten Versiegelungsschicht beschichtet. Auch kann das poröse Material vor dem Einbringen in der Behälterinnenraum mit Sauerstoff aufgeladen und mit einer gasdichten Versiegelungsschicht beschichtet werden.

Auch kann die Keramikschicht vor dem Stapeln an ihrer Ober- und/oder Unterseite vollflächig mit einer Hartlotschicht bzw. einer Aktivlotschicht beschichtet werden, wodurch ein zusätzliches Hartlöten der Metallschicht und der Keramikschicht bei reduzierter Lotmenge möglich ist.

Ferner ist Gegenstand der vorliegende Erfindung eine alternatives Verfahren zur Herstellung eines Metall-Keramik-Substrates umfassend eine erste und zweite Metallisierung und zumindest eine zwischen der ersten und zweiten Metallisierung aufgenommene Keramikschicht mit einer Ober- und Unterseite, bei dem auf die Ober- und Unterseite der Keramikschicht randseitig eine umlaufende, rahmenartige, vorzugsweise kontinuierliche Lotschicht aufgebracht wird, bei dem eine erste und zweite Metallschicht und die Keramikschicht übereinander gestapelt werden und durch Erhitzen zumindest im Bereich der umlaufenden, rahmenartigen Lotschicht eine randseitige Lotverbindung erzeugt wird, und zwar derart, dass zwischen der Keramikschicht und der jeweiligen Metallschicht ein gasdicht abgeschlossener, spaltartiger Zwischenraum entsteht, bei dem die Metallschichten und die Keramikschicht in einer Behandlungskammer bei einem Gasdruck zwischen 500 und 2000 bar und einer Prozesstemperatur zwischen 300°C bis zur Schmelztemperatur der Metallschichten oder der Lotschicht heißisostatisch miteinander verpresst werden und bei dem zumindest die über die umlaufende, rahmenartige Lotverbindung mit der Keramikschicht verbundenen Randbereiche der Metallschichten zur Bildung der ersten und zweiten Metallisierung entfernt werden.

Vorzugsweise werden zumindest die über die randseitige Lotverbindung mit der Keramikschicht verbundenen Randbereiche der Metallschichten zur Bildung der ersten und zweiten Metallisierung entfernt.

In einer Ausführungsvariante beider Verfahren wird eine der Metallschichten vor dem heißisostatischen Verpressen unter Verwendung eines Direct-Copper-Bonding-Verfahrens oder eines Hartlot- bzw. Aktivlotverfahrens mit der Keramikschicht verbunden. Insbesondere kann es wünschenswert sein, lediglich eine der Metallisierungen mit einer Schichtdicke ab 50 Mikrometer auszubilden, wohingegen für die gegenüberliegende weitere Metallisierung eine nach bekannten Verbindungsverfahren hergestellte Metallisierung mit einer Schichtdicke ab 200 Mikrometer ausreichen ist, beispielsweise zur Anbindung einer Kühlanordnung.

Weiterhin vorteilhaft kann zwischen der ersten Metallschicht und der Keramikschicht und/oder zwischen der zweiten Metallschicht und der Keramikschicht zumindest eine weitere Metallschicht, vorzugsweise aus Kupfer oder Aluminium beim Stapeln eingebracht werden. Vorzugsweise werden jeweils eine erste Metallschicht aus Kupfer und eine weiter Metallschicht aus Aluminium vorgesehen, die entweder lose übereinander gestapelt oder direkt miteinander verbunden, beispielsweise miteinander verschweißt oder walzplattiert sind. Die weitere Metallschicht kann im Vergleich zu den Abmessungen der Keramikschicht unterschiedlich dimensioniert sein, beispielsweise innerhalb des Randbereiches der Keramikschicht aufgenommen sein oder mit diesem bündig verlaufen oder sich über den Randbereich der Keramikschicht erstrecken, jedoch maximal so weit, dass die erste und weitere Keramikschicht einen bündigen Randverlauf aufweisen.

Weiterhin vorteilhaft werden die Schichten mittels eines Hilfswerkzeuges umfassend zwei, vorzugsweise gegenüberliegende Halbschalen zum randseitigen Verbinden der Metallschichten gegeneinander verspannt.

Gemäß einer bevorzugten Ausführungsvariante des erfindungsgemäßen Verfahrens wird zumindest eine der Metallschichten und/oder die Ober- und/oder Unterseite der Keramikschicht vor dem Stapeln mit einer Oxidschicht versehen. Beispielsweise kann die zur Verbindung vorgesehene Oberfläche der Metallschichten oxidiert werden oder die Keramikschicht einer Vorbehandlung und einer thermischen Oxidation unterzogen werden.

Die Ausdrucke "näherungsweise", "im Wesentlichen" oder "etwa" bedeuten im Sinne der Erfindung Abweichungen vom jeweils exakten Wert um +/- 10%, bevorzugt um +/- 5% und/oder Abweichungen in Form von für die Funktion unbedeutenden Änderungen.

Weiterbildungen, Vorteile und Anwendungsmöglichkeiten der Erfindung ergeben sich auch aus der nachfolgenden Beschreibung von Ausführungsbeispielen und aus den Figuren. Auch wird der Inhalt der Ansprüche zu einem Bestandteil der Beschreibung gemacht.

Die Erfindung wird im Folgenden anhand der Figuren an Ausführungsbeispielen näher erläutert. Es zeigen:
- Fig. 1: eine vereinfachte schematische Schnittdarstellung durch ein Metall-Keramik-Substrat,
- Fig. 2: eine vereinfachte Schnittdarstellung durch einen Stapel aus einer ersten und zweiten Metallschicht und einer dazwischen aufgenommenen Keramikschicht,
- Fig. 3: einen schematische Schnittdarstellung durch einen aus dem Stapel gemäß Figur 2 gebildeten Metallbehälter mit im Behälterinneren aufgenommener Keramikschicht,
- Fig. 4: eine schematische Draufsicht auf den Metallbehälter gemäß Figur 3,
- Fig. 5: eine schematische Schnittdarstellung durch einen Metallbehälter mit im Behälterinneren aufgenommener Keramikschicht und zusätzlicher poröser Hilfskeramikschicht,
- Fig. 6: eine vereinfachte schematische Schnittdarstellung durch den in einem Hilfswerkzeug aufgenommenen Metallbehälter gemäß Figur 3,
- Fig. 7: eine vereinfachte schematische Schnittdarstellung durch einen Stapel aus einer ersten und zweiten Metallschicht und einer dazwischen aufgenommenen Keramikschicht, die randseitig über eine umlaufende, rahmenartige Lotverbindung verbunden sind,
- Fig. 8: eine schematische Draufsicht auf den Stapel gemäß Figur 6 und
- Fig. 9a-d: mehrere Ausführungsvarianten eines Stapels umfassen vier Metallschichten und eine Keramikschicht zur Herstellung eines Metall-Keramik-Substrates nach dem erfindungsgemäßen Verfahren.

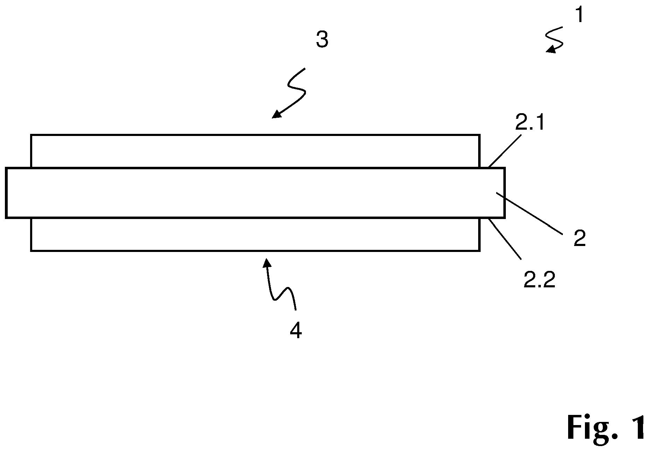

Figur 1 zeigt in vereinfachter schematischer Darstellung einen Schnitt durch eine übliche Ausführungsform eines Metall-Keramik-Substrates 1 umfassend eine Keramikschicht 2 mit einer Oberseite 2.1 und einer Unterseite 2.2, welche jeweils mit einer Metallisierung 3, 4 versehen ist, und zwar weist die Oberseite 2.1 eine erste Metallisierung 3 und die Unterseite 2.2 eine zweite Metallisierung 4 auf.

Die Metallisierungen 3, 4 können aus demselben oder unterschiedlichen Metall(en) hergestellt sein und zum Aufbau von Kontaktflächen und/oder einer elektronischen Schaltung strukturiert ausgebildet sein. Hierbei sind die erste und zweite Metallisierung 3, 4 vorzugsweise direkt flächig mit der Ober- bzw. Unterseite 2.1, 2.2 verbunden.

Die erste und zweite Metallisierung 3, 4 sind beispielsweise aus Kupfer oder einer Kupferlegierung oder Aluminium oder einer Aluminiumlegierung hergestellt. Die Schichtdicke der ersten und zweiten Metallisierung 3, 4 beträgt wenigstens 20 Mikrometer, vorzugsweise zwischen 20 und 900 Mikrometer, wobei im Bereich der Leistungselektronik vorzugsweise Schichtdicken zwischen 150 und 600 Mikrometer und im LED-Bereich vorzugsweise Schichtdicken zwischen 50 und 150 Mikrometer Anwendung finden. Es versteht sich, dass auch andere geeignete Metalle zur Herstellung der Metallisierungen 3, 4 Anwendung finden können.

Die Keramikschicht 2 ist beispielsweise aus einer Oxid-, Nitrid- oder Karbidkeramik wie Aluminiumoxid (Al2O3) oder Aluminiumnitrid (AIN) oder Siliziumnitrid (Si3N4) oder Siliziumkarbid (SiC) oder aus Aluminiumoxid mit Zirkonoxid (Al2O3 + ZrO2) hergestellt und weist eine Schichtdicke beispielsweise zwischen 50 Mikrometer und 1000 Mikrometer, vorzugsweise zwischen 200 Mikrometer und 700 Mikrometer auf.

Hier setzt die Erfindung an und schlägt ein effizientes Verfahren zur Herstellung eines Metall-Keramik-Substrates 1 umfassend eine derartige erste und zweite Metallisierung 3, 4 und zumindest eine zwischen der ersten und zweiten Metallisierung 3, 4 aufgenommene Keramikschicht 2 vor. Die direkte flächige Verbindung zwischen den jeweiligen Metallisierungen 3, 4 und der Keramikschicht 2 wird erfindungsgemäß durch Anwendung eines druckinduzierten Verbindungsverfahrens, und zwar des heißisostatischen Pressverfahrens (HIP-Verfahren) hergestellt, um das Entstehen von Lunkern bzw. Mikrolunkern im Verbindungsbereich zwischen der jeweiligen Metallisierung 3, 4 und der Keramikschicht 2 effektiv zu verhindern. Auch können mittels des heißisostatischen Pressverfahrens im Vergleich zum DCB-Verfahren deutlich dünnere Metallschichten 5, 6 verarbeitet werden, beispielsweise bereits ab einer Mindestschichtdicke von ca. 50 Mikrometer.

Die prinzipielle Funktionsweise des heißisostatischen Pressverfahrens bzw. so genannten HIP-Verfahrens oder HIP-Prozesses ist bekannt. Der auf die zu verbindenden Schichten vorzugsweise flächig aufgebrachte Druck kann hierbei mechanisch und/oder mittels eines Gases oder Fluides erzeugt werden. Vorteilhaft können bei Verwendung des HIP-Verfahrens zur Herstellung einer vorzugsweise flächigen Verbindung zwischen den Metallisierungen 3, 4 und der Keramikschicht 2 im Vergleich zu den weiteren Verbindungsverfahren die Schichtdicke reduziert werden kann, insbesondere können Metallschichten einer Dicke von 50 Mikrometer und mehr verarbeitet werden.

Zum druckinduzierten flächigen Verbinden der ersten und zweiten Metallisierung 3, 4 mit der Keramikschicht 2 werden zunächst eine erste und zweite Metallschicht 5, 6 vorgesehen, die zusammen mit der Keramikschicht 2 übereinander gestapelt werden, und zwar derart, dass die Keramikschicht 2 zwischen den Metallschichten 5, 6 aufgenommen ist. Damit liegt bereits die Schichtfolge des in Figur 1 dargestellten Metall-Keramik-Substrates 1 vor, wobei die erste und zweite Metallschicht 5, 6 und die Keramikschicht 2 noch keine flächige Verbindung aufweisen.

Die erste und zweite Metallschicht 5, 6 sind hinsichtlich ihrer Querschnittsform im Wesentlichen an die Querschnittsform der Keramikschicht 2 angepasst. Vorzugsweise weist die Keramikschicht 2 eine rechteckförmige oder quadratische Querschnittsform auf. Alternativ kann jedoch auch die Keramikschicht 2 rund, oval oder eine in sonstiger Weise polygone Querschnittsform besitzen.

Die erste und zweite Metallschicht 5, 6 überlappen mit ihren freien Randabschnitten 5a, 6a den freien Rand 2' der Keramikschicht 2, und zwar über den vollständigen Verlauf des freien Randes 2' der Keramikschicht 2. Somit stehen die erste und zweite Metallschicht 5, 6 mit ihren freien Randabschnitten 5a, 6a jeweils vom freien Rand 2a der Keramikschicht 2 nach außen über, und zwar beispielsweise über eine Länge L von zwischen 3 mm und 30 mm. Die Länge L ist hierbei abhängig von der Schichtdicke der ersten und zweiten Metallschicht 5, 6 gewählt.

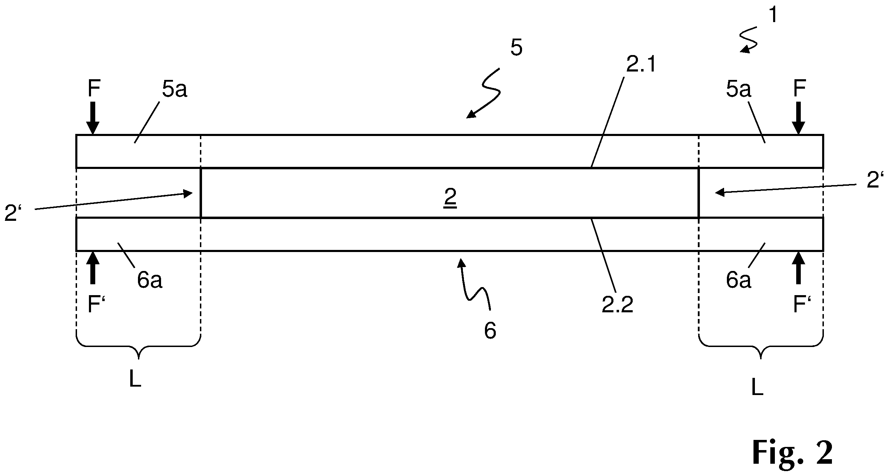

Im vorliegenden Ausführungsbeispiel wird gemäß Figur 2 ein Stapel aus der ersten und zweiten Metallschicht 5, 6 und der Keramikschicht 2 gebildet, wobei auf der zweiten Metallschicht 6 die Keramikschicht 2 flächig aufliegt und auf diese dann die erste Metallschicht 5 folgt, d.h. die Keramikschicht 2 ist zwischen der ersten und zweiten Metallschicht 5, 6 im Stapel aufgenommen und die freien Randabschnitte 5a, 6a der ersten und zweiten Metallschichten 5, 6 stehen randseitig über die Keramikschicht 2 über.

Anschließend wird erfindungsgemäß aus der ersten und zweiten Metallschicht 5, 6 ein gasdicht verschlossener Metallbehälter 7 mit einem Behälterinneren 8 gebildet, in dem die Keramikschicht 2 vollständig aufgenommen ist. Hierzu werden die ersten und zweiten Metallschichten 5, 6 im Bereich der überstehenden freien Randabschnitte 5a, 6a zueinander verformt, und zwar durch Beaufschlagung mit vorzugsweise senkrecht zur Oberfläche der Metallschicht 5, 6 wirkenden seitlichen Spannkräften F, F', welche jeweils in Richtung der Ober- bzw. Unterseite 2.1, 2.2 der Keramikschicht 2 orientiert sind. Die der Keramikschicht 2 unmittelbar benachbarten ebenen Abschnitte der ersten und zweiten Metallschicht 5, 6 verlaufen hierbei vorzugsweise parallel zu der Ober- bzw. Unterseite 2.1, 2.2 der Keramikschicht 2. Der Metallbehälter 7 weist damit im Wesentlichen zwei halbschalenartige Behälterhälften 7.1, 7.2 auf, welche durch die erste und zweite, verformte Metallschicht 5, 6 gebildet werden.

Im vorliegenden Ausführungsbeispiel werden die freien Randabschnitte 5a der ersten Metallschicht 5 mit einer vertikal nach unten, d.h. in Richtung der Keramikschicht 2 wirkenden Spannkraft F und die freien Randabschnitte 6a der zweiten Metallschicht 6 mit einer vertikal nach oben, d.h. in Richtung der Keramikschicht 2 wirkenden Spannkraft F' beaufschlagt und damit zueinander verspannt und dadurch eine entsprechende Verformung der Metallschichten 5, 6 in ihren freien Randabschnitten 5a, 6a erreicht. Die entsprechend verformten freien Randabschnitte 5a, 6a werden direkt miteinander verbunden, und zwar entlang eines umlaufenden, d.h. ringförmigen Verbindungsbereiches VB. Vorzugsweise ergeben die freien Randabschnitte 5a, 6a einen bündig verlaufenden, gasdicht verschlossenen Rand des Metallbehälters 7. Der Metallbehälter 7 bildet somit eine Kapselung der Keramikschicht 2 mittels der halbschalenartig ausgebildeten und gasdicht miteinander verbundenen Behälterhälften 7.1, 7.2 aus.

Die randseitige direkte Verbindung der verformten freien Randabschnitte 5a, 6a im ringförmigen Verbindungsbereich VB erfolgt vorzugsweise durch Schweißen, insbesondere Kontaktschweißen oder Laserschweißen oder durch Löten, auch Hartlöten. Alternativ kann die randseitige direkte Verbindung auch mittels eines mechanischen Verbindungs- und/oder Bearbeitungsverfahren hergestellt werden, und zwar durch Walzen, Verpressen und/oder Umbördeln der freien Randabschnitte 5a, 6a, wobei auch hier eine randseitige gasdichte mechanische Verbindung zwischen den beiden Metallschichten 5, 6 entlang des ringförmigen Verbindungsbereiches VB entsteht. Bei einer Verbindung mittels Laserschweißen werden vorzugsweise die freien Randabschnitte 5a, 6a an den Außenkanten miteinander verschweißt, und zwar vorzugsweise in einem Winkel zwischen 45° und 90°. In einer Ausführungsvariante erfolgt das randseitige direkte Verbindung in einer für den Verbindungsprozess vorteilhaften Atmosphäre, beispielsweise im Vakuum, in einer Luftatmosphäre oder einer Inertgasatmosphäre unter Verwendung von beispielsweise Stickstoff oder Argon als Inertgas.

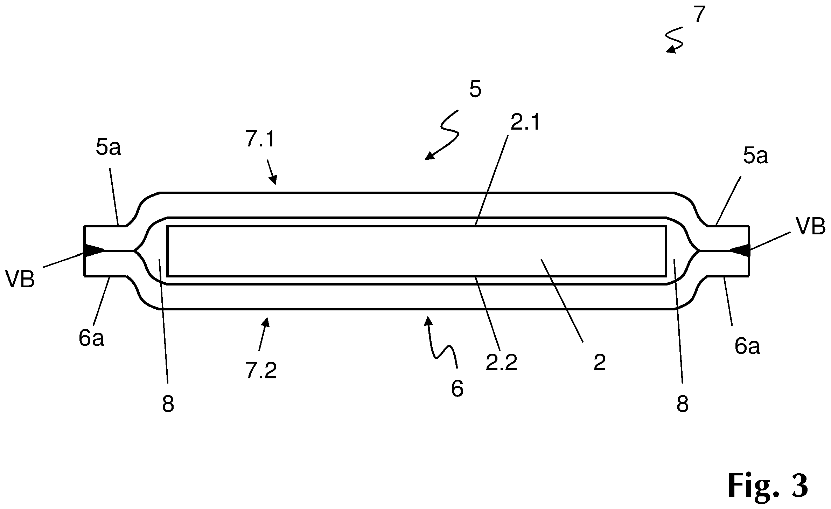

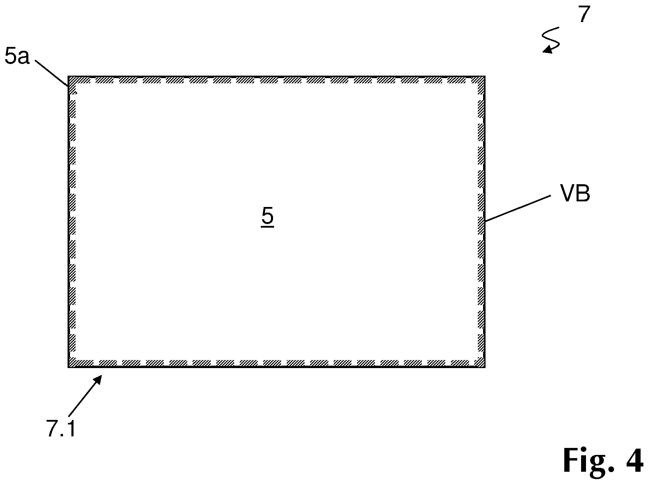

In Figur 3 ist beispielhaft ein schematischer Schnitt durch den Metallbehälter 7 mit der im Behälterinneren 8 aufgenommenen Keramikschicht 2 dargestellt, aus der die halbschalenartige Ausbildung der Behälterhälften ebenfalls ersichtlich ist. Figur 4 zeigt beispielhaft eine Draufsicht auf den Metallbehälter 7 und den mittels einer strichliert gezeichneten Linie angedeuteten Verlaufes des ringförmigen Verbindungsbereiches VB.

Anschließend werden die den Metallbehälter 1 bildenden Metallschichten 5, 6 mit der im Behälterinneren 8 aufgenommener Keramikschicht 2 in einer nicht in den Figuren dargestellten Behandlungskammer bei einem Gasdruck zwischen 500 und 2000 bar und einer Prozesstemperatur zwischen 300°C bis zur Schmelztemperatur der Metallschichten 5, 6 heißisostatisch miteinander verpresst. Hierdurch wird eine Diffusionsverbindung zwischen der Oberseite 2.1 der Keramikschicht 2 und dem mit dieser in direkter Verbindung stehenden Abschnitt der ersten Metallschicht 5 sowie zwischen der Unterseite 2.2 der Keramikschicht 2 und dem mit dieser in direkter Verbindung stehenden Abschnitt der zweiten Metallschicht 6 hergestellt, welches keine Lunker bzw. Mikrolunker und eine hohe Haftkraft aufweist.

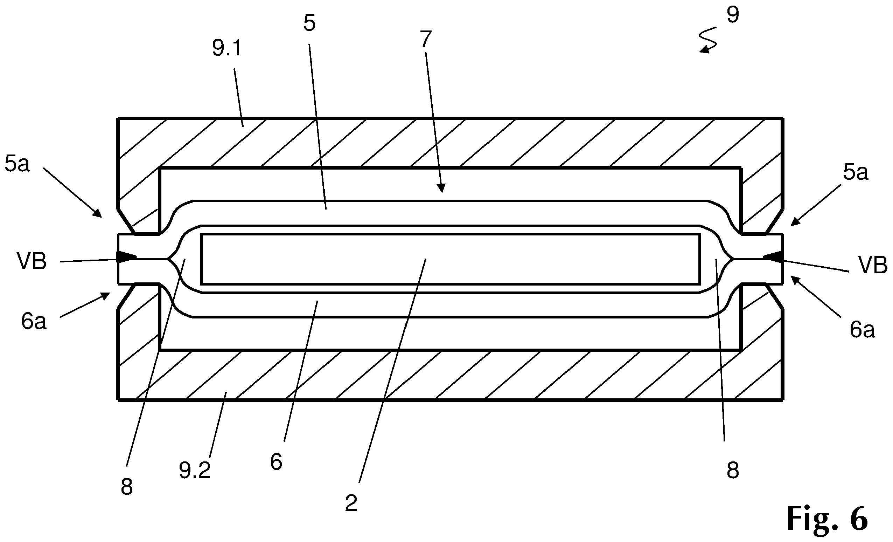

Mittels eines Hilfswerkzeuges 9 mit beispielsweise zwei Halbschalen 9.1, 9.2 wird der Metallbehälter 1 im Bereich der freien Randabschnitte 5a, 6a, vorzugsweise entlang des ringförmigen Verbindungsbereiches VB, mit einer Spannkraft F, F' beaufschlagt und damit eingeklemmt. Dies vereinfacht das Herstellen einer randseitigen direkten Verbindung zwischen den freien Randabschnitten 5a, 6a, insbesondere einer Laserschweißverbindung. Auch können hierdurch noch Arbeitsmedium wie Sauerstoff oder dergleichen in den Behälterinnenraum 8 eingebracht werden, ohne dass dieser bereits dauerhaft verschlossen ist. Figur 6 zeigt beispielhaft einen Schnitt durch einen im Hilfswerkzeug 9 aufgenommen Metallbehälter 1.

Nach dem zumindest abschnittsweisen heißisostatischen Verpressen der Metallschichten 5, 6 bzw. der Behälterhälften 7.1, 7.2 mit der Keramikschicht 2 werden die freien Randabschnitte 5a, 6a entfernt, vorzugsweise durch ein mechanisches Bearbeitungsverfahren oder ein geeignetes Ätzverfahren. Die verbleibenden mit der Ober- und Unterseite 2.1, 2.2 der Keramikschicht 2 verbundenen Abschnitte der ersten und zweiten Metallschicht 5, 6 bilden die erste und zweite Metallisierung 3, 4 des Metall-Keramik-Substrates 1.

In einer Ausführungsvariante erfolgt das Beaufschlagen der Metallschichten 5, 6 mit der Spannkraft F, F' sowie das anschließende randseitige Verbinden der freien Randabschnitte 5a, 6a in der Umgebungsatmosphäre, d.h. auch nach dem Verschließen des eine Kapselung der Keramikschicht 2 bildenden Metallbehälters 7 befindet sich im Behälterinneren 8 zumindest noch Restluft bzw. ein Restgas. Aufgrund der Restluft bzw. des Restgases können jedoch Einschlüsse im Verbindungsbereich zwischen den Metallschichten 5, 6 und der Keramikschicht 2 bei Durchführung des HIP-Verfahrens entstehen.

Die Metallschichten 5, 6 und die Keramikschicht 2 werden in einer Ausführungsvariante zunächst gestapelt und unter Luftatmosphäre verspannt, beispielsweise mittels des Hilfswerkzeuges 9 und anschließend randseitig direkt miteinander verbunden.

Gemäß einer weiteren Ausführungsvariante wird zur Vermeidung von Einschlüssen vor dem randseitigen direkten Verbinden der freien Randabschnitte 5a, 6a der Metallschichten 5, 6 der Behälterinnenraum 8 vakuumiert und dadurch die im Behälterinnenraum 8 vorhandene Restluft bzw. das darin vorhandene Restgas vorzugsweise vollständig entfernt.

Ferner kann die Haftkraft der druckinduzierten direkten Verbindung durch Erzeugen einer Oxidschicht auf der Ober- bzw. Unterseite 2.1, 2.2 während des HIP-Verfahrens erhöht werden. Der Sauerstoffanteil in der Umgebungsatmosphäre ist jedoch häufig zu gering, damit eine entsprechende Oxidschicht auf den Metallschichten 5, 6 und/oder der Keramikschicht 2 entstehen kann. Vorzugsweise weist eine derartige Oxidschicht eine Kupferdotierung auf.

Um das Entstehung einer entsprechenden Oxidschicht zu unterstützen kann dem Herstellungsprozess Sauerstoff zugeführt werden, und zwar können die Metallschichten 5, 6 bereits beim Formen des Stapel mit Sauerstoff beaufschlagt werden.

Alternativ oder zusätzlich kann in den Behälterinnenraum 8 vor dem randseitigen Verbinden der Metallschichten 5, 6 Sauerstoff eingebracht werden oder die Metallschichten 5, 6 mit Sauerstoff vorbehandelt werden. Ein derartiges Fluten des Behälterinnenraumes 8 mit Sauerstoff erfolgt beispielsweise vor dem randseitigen Verspannen der Metallschichten 5, 6 oder nach dem Vakuumieren des Behälterinnenraumes 8.

Auch kann die Entstehung einer Oxidschicht durch eine Vorbehandlung der Keramikschicht 2 effektiv unterstützt werden, und zwar beispielsweise durch Aufbringen einer Hilfsschicht mittels eines mechanisch chemischen Verfahrens. Bei diesem mechanisch chemischen Verfahren wird auf zumindest eine Seite 2.1, 2.2 der Keramikschicht 2, insbesondere eines AlN-Substrates zur Herstellung der Hilfsschicht eine Schicht aus Kupfer, Kupferoxid oder anderen kupferhaltigen Verbindungen aufgebracht. Das Aufbringung dieser Hilfsschicht kann unter Verwendung alternativer Verfahren erfolgen. Kupfer, Kupferoxid oder andere kupferhaltigen Verbindungen können beispielsweise mittels Sputter-Prozessen, stromloser Abscheidung von Kupfer mit einem handelsüblichen Bad, Aufdampfen, Siebdrucken, Tauchen in Lösungen usw. aufgebracht werden. Anschließend wird die Keramikschicht 2, insbesondere das AlN-Substrat einem Oxidationsvorgang unterworfen, mittels dem Kupfer, Kupferoxid bzw. andere Kupferverbindungen oxidiert werden.

Insbesondere ist bei Verwendung einer Aluminiumnitrid-Keramikschicht 2 zur Herstellung des Metall-Keramik-Substrates 1 die bei der Durchführung des HIP-Pressverfahrens entstehende mechanische Verzahnung der gegenüberliegenden Schichten 2, 5, 6 bereits ausreichend haftstark, d.h. eine zusätzlich Erzeugung einer Zwischenschicht ist nicht erforderlich, da sich auf der Oberfläche der Aluminiumnitrid-Keramikschicht 2 aufgrund des Umgebungssauerstoffes sich selbst eine Oxidschicht bildet, welche ausreichend ist um eine Verbindung herzustellen.

Bei Verwendung einer Siliziumnitrid-Keramikschicht 2 ist ebenfalls keine Vorbehandlung zur Erzeugung einer Zwischenschicht notwendig. Der Umgebungssauerstoff bzw. der Restsauerstoff im Behälterinnenraum ist ausreichend um eine für den Verbindungsprozess vorteilhafte Siliziumdioxidschicht entstehen zu lassen.

Um die Bildung einer natürlichen Oxidschicht auf der Keramikoberfläche zu fördern kann die mit der Keramikschicht 2 zu verbindende Metallschicht 5, 6 mit Sauerstoff angereichert werden. Dieser Sauerstoff kann von den angereicherten Metallschichten 5, 6 während des HIP-Pressverfahrens freigegeben werden.

In einer Ausführungsvariante ist ein Spülen des Behälterinnenraumes 8 nach dem Verspannen mit einem Inertgas, beispielsweise Stickstoff oder Argon denkbar.

In einer alternativen Ausführungsvariante kann zur Aufnahme der im Behälterinnenraum 8 befindlichen Restluft bzw. des Restgases zusätzlich zu der Keramikschicht 2 im Behälterinnenraum 8 ein poröses Material 11, beispielsweise Metall oder Keramik aufgenommen werden, die ein Aufnahmereservoir für das im Behälterinnenraum 8 befindliche Restgases bei Durchführung des HIP-Verfahrens bildet. Mittels des porösen Materials 11 wird eine für die Durchführung des HIP-Verfahrens vorteilhafte Atmosphäre geschaffen.

Das poröse Material 11 wird vorzugsweise vor dem Einbringen in den Behälterinnenraum 8 vakuumiert. In einer Ausführungsvariante wird das poröse Material 11 vor dem Einbringen in den Behälterinnenraum 8 mit einer gasdichten Versiegelungsschicht 12 versehen, wobei auch poröse Materialien 11 ohne eine gasdichte Versiegelungsschicht 12 Anwendung finden können. Bei Durchführung des HIP-Verfahrens wird die gasdichte Versiegelungsschicht 12 aufgebrochen und von der vakuumierten porösen Hilfskeramikschicht 11 das im Behälterinnenraum 8 vorhandene Restgas gezielt aufgenommen.

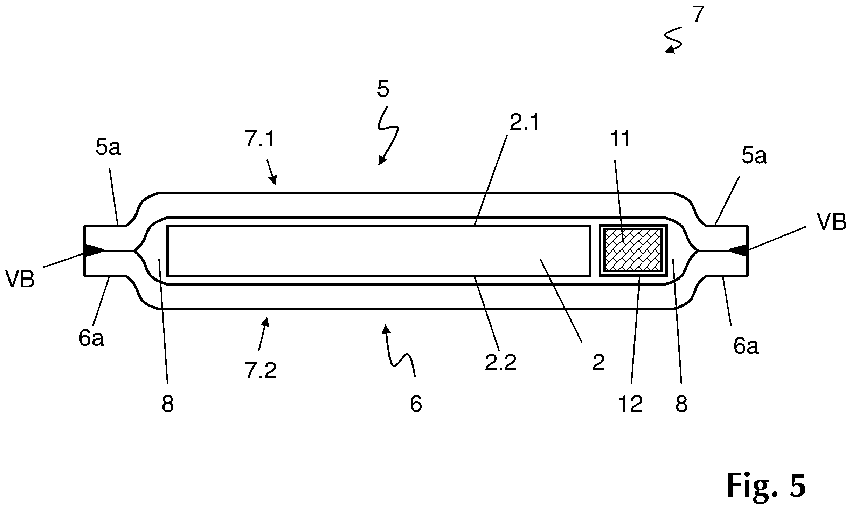

Alternativ oder zusätzlich kann das poröse Material 11, insbesondere vor dem Aufbringen einer gasdichten Versiegelungsschicht 12 in einer Sauerstoffatmosphäre mit Sauerstoff aufgeladen werden. Die gasdichte Versiegelungsschicht 12 bildet hierbei jeweils eine gasdichte Ummantelung des porösen Materials 11 aus. Figur 5 zeigt beispielhaft einen Schnitt durch einen Metallbehälter 7 gemäß Figur 3, in dem zusätzlich zur Keramikschicht 2 zumindest eine poröse Hilfskeramikschicht 11 mit gasdichter Versiegelungsschicht 12 aufgenommen ist. Es versteht sich, dass auch mehrere Schichten derartiger poröser Materialien 11 in unterschiedlicher Form und Anordnung innerhalb des Metallbehälters 7 vorgesehen werden können.

Das poröse Material 11 kann auch beispielsweise mit einer Kupferoxidschicht versehen sein. Eine derartige CuO-Schicht wird beim HIP-Verfahren in Sauerstoff und Cu2O umgewandelt. Der hierbei freiwerdende Sauerstoff trägt zur Oxidation der Metallschichten 5, 6 bzw. der Keramikschicht 2 bei. Neben CuO können auch weitere Oxide Verwendung finden, die unter den Prozessparametern des HIP-Verfahrens, insbesondere Temperatur und Druck Sauerstoff freisetzen und die Bildung einer Oxidschicht begünstigen, und zwar beispielsweise MnO, VO, TiO und Mo3O.

In einer weiteren Ausführungsvariante sind die erste Metallschicht 5 aus Kupfer oder einer Kupferlegierung und die zweite Metallschicht 6 aus Aluminium oder einer Aluminiumlegierung hergestellt.

Auch beispielsweise zwischen der Keramikschicht 2 und einer ersten Metallschicht 5 aus Kupfer eine weitere Metallschicht 5' aus Aluminium vorgesehen, die ebenfalls übereinander gestapelt werden. Analog hierzu kann auch zwischen der zweiten Metallschicht 6 und der Keramikschicht 2 eine weitere Metallschicht 6' aufgenommen sein. Vorzugsweise sind die erste bzw. zweite Metallschicht 5, 6 und die jeweils weitere Metallschicht 5', 6' mittels Walzplattieren miteinander verbunden.

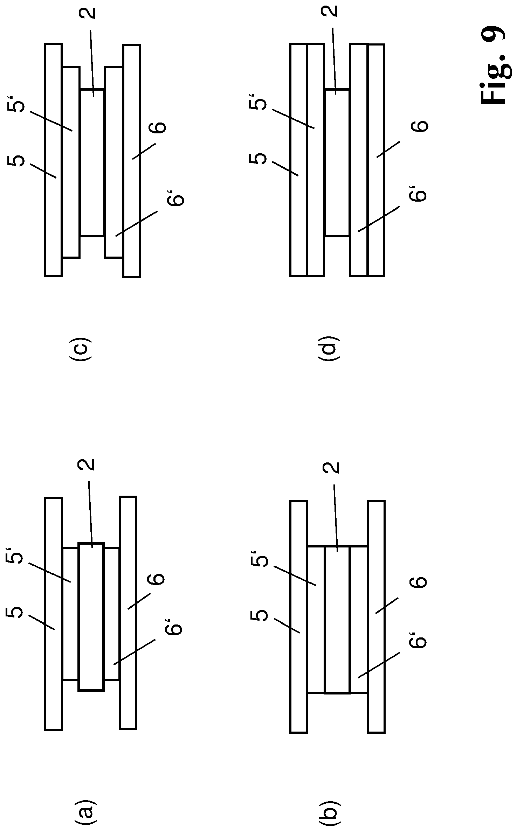

In Figur 9 sind beispielshaft unterschiedliche Ausführungsvarianten (a) bis (d) eines Metall-Keramik-Substrates 1 mit einer ersten Metallschicht 5 aus Kupfer einer weiteren Metallschicht 5' aus Aluminium sowie einer zweiten Metallschicht 6 aus Kupfer und einer weiteren Metallschicht 6' aus Aluminium, die mittels des erfindungsgemäßen Verfahrens miteinander verbunden werden. Bei den Ausführungsvarianten (a), (b) und (c) sind die Metallschichten 5, 6, 5', 6' lose übereinander gestapelt, wohingegen bei der Ausführungsvariante (d) eine Verbindung zwischen den oberen und unteren beiden Metallschichten 5, 5' bzw. 6, 6' besteht. Die Verbindung kann entweder durch Walzplattieren der Kupfer- und Aluminiumschicht 5, 5' bzw. 6, 6' oder durch ein randseitiges Verschweißen hergestellt sein. Bei der Ausführungsvariante (a) erstreckt sich jeweils die weitere Metallschicht 5', 6' nur teilweise über die Ober- bzw. Unterseite 2.1, 2.2 der Keramikschicht, d.h. diese ist randseitig versetzt nach innen angeordnet. Die Ausführungsvariante (b) zeigt einen bündigen Randverlauf der weiteren Metallschicht 5', 6' mit der Keramikschicht 2 und gemäß der Ausführungsvariante (c) erstreckt sich die weiteren Metallschicht 5', 6' über den freien Rand 2' der Keramikschicht 2, jedoch innerhalb des Randes der ersten und zweiten Metallschicht 5, 6. Bei der Ausführungsvariante (d) weisen die erste Metallschicht 5 und die zugeordnete weitere Metallschicht 5' und/oder die zweiten Metallschicht 6 und die weitere Metallschicht 6' jeweils einen bündigen Randverlauf aus, d.h. diese sind hinsichtlich Form identisch zueinander ausgebildet. Desweiteren ist es möglich, einen unterschiedlichen Schichtaufbau auf der Ober- und Unterseite 2.1, 2.2 der Keramikschicht 2 vorzusehen bzw. eine Kombination der in Figur 9 dargestellten Ausführungsvarianten (a) bis (d) vorzusehen.

Weiterhin kann die Keramikschicht 2 bzw. dessen Ober- und/oder Unterseite 2.1, 2.2 vor der Durchführung des erfindungsgemäßen Verfahrens vollflächig mit einer Hartlotschicht beschichtet werden. Der Lötprozess wird hierdurch so zusagen in das HIP-Verfahren integriert. Vorteilhaft kann hierbei die Schichtdicke der Hartlotschicht im Vergleich zum bekannten Aktivlotverfahren reduziert werden, d.h. vorteilhaft ist eine geringe Lotmenge erforderlich, da aufgrund des HIP-Verfahrens die Metallschichten 5, 6 auch in Unebeneinheiten der Ober- und/oder Unterseite 2.1, 2.2 gepresst werden.

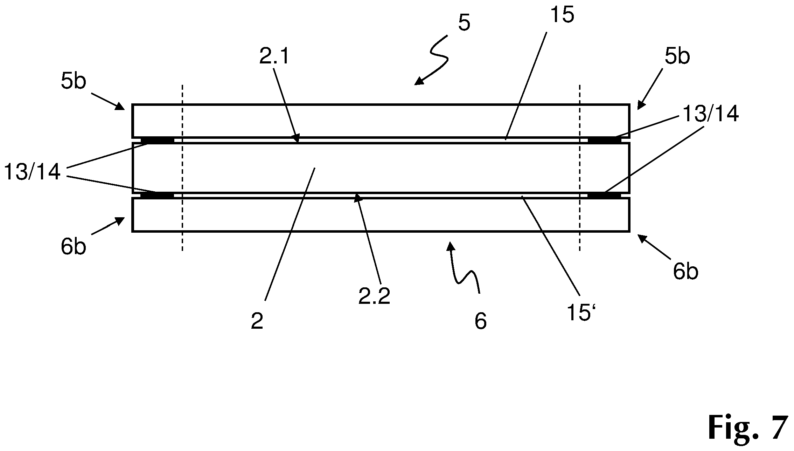

In den Figuren 7 bis 8 wird ein zur Kapselung der Keramikschicht 2 in einem Metallbehälter 7 alternatives Verfahren zur Herstellung eines Metall-Keramik-Substrates 1 beschrieben. Gemäß diesem wird die Keramikschicht 2 an der Ober- und Unterseite 2.1, 2.2 jeweils randseitig mit einer umlaufenden, rahmenartigen Lotschicht 13 versehen und anschließend ein Stapel aus der ersten und zweiten Metallschicht 5, 6 und der Keramikschicht 2 gebildet.

In einem nächsten Schritt wird der Stapel derart erhitzt, dass die vorbereitete umlaufende, rahmenartige Lotschicht 13 zu einer randseitigen Lotverbindung 14 zwischen der jeweiligen Metallschicht 5, 6 und der Keramikschicht 2 führt. Aufgrund der Erhitzung und der vorherigen Vakuumierung des schlitzartigen Zwischenraumes 15, 15' zwischen der jeweiligen Metallschicht 5, 6 und der Keramikschicht 2 liegt eine vorteilhafte Atmosphäre für die Durchführung des heißisostatischen Pressverfahrens bzw. HIP-Verfahrens vor.

Die randseitige Lotverbindung 14 bildet ebenfalls einen vorzugsweise ringförmigen Verbindungsbereich VB' aus. Schließlich wird der über die randseitige Lotverbindung 14 gebildete Stapel aus der ersten und zweiten Metallschicht 5, 6 und der Keramikschicht 2 wiederum in eine nicht dargestellte Behandlungskammer eingebracht und bei einem Gasdruck zwischen 500 und 2000 bar und einer Prozesstemperatur zwischen 300°C bis zur Schmelztemperatur der Metallschichten 5, 6 oder der Lotschicht 13 diese mit der Keramikschicht 2 heißisostatisch verpresst. Hierbei bilden die flächig mit der Keramikschicht 2 verbundenen Abschnitte der jeweiligen Metallschicht 5, 6 die Metallisierungen 3, 4 des Metall-Keramik-Substrates 1 aus.

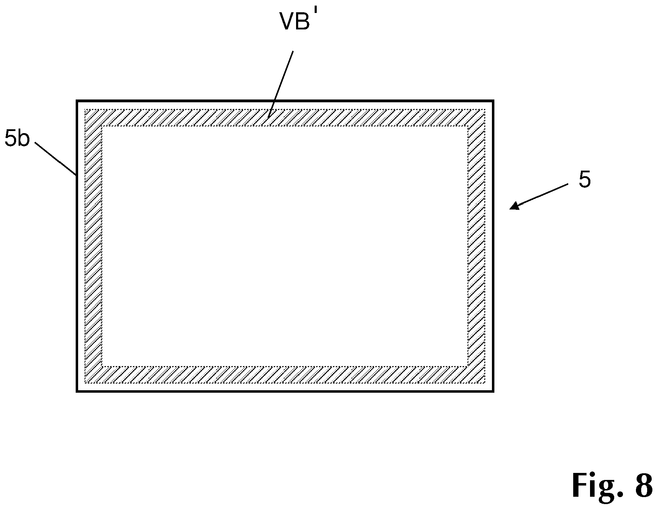

Die mittels der Keramikschicht 2 über die randseitige Lotverbindung 14 verbundenen Randbereiche 5b, 6b der Metallschicht 5, 6 werden zur Abgrenzung der ersten und zweiten Metallisierung 3, 4 entfernt, und zwar durch eine mechanisches Bearbeitungsverfahren oder mittels eines Lasers oder eines geeigneten Ätzverfahrens. Die verbleibenden Abschnitte der ersten und zweiten Metallschichten 5, 6 bilden damit die erste und zweite Metallisierung 3, 4 des Metall-Keramik-Substrates 1 aus. Die umlaufende, rahmenartige Lotschicht 13 ist beispielsweise kontinuierlich ausgebildet, und zwar vorzugsweise in Form eines geschlossenen Ringes. Figur 8 zeigt beispielhaft den Verlauf der auf der Oberseite 2.1 der Keramikschicht 2 aufgebrachten umlaufenden, rahmenartigen Lotschicht 13.

In einer Ausführungsvariante beider Verfahren wird eine der Metallschichten vor dem heißisostatischen Verpressen unter Verwendung eines Direct-Copper-Bonding-Verfahrens oder eines Hartlot- bzw. Aktivlotverfahrens mit der Keramikschicht verbunden. Hierdurch können Metallisierungen mit unterschiedlicher Schichtdicke ab 50 Mikrometer hergestellt werden.

Die Erfindung wurde voranstehend an Ausführungsbeispielen beschrieben. Es versteht sich, dass zahlreiche Änderungen sowie Abwandlungen möglich sind, ohne dass dadurch der der Erfindung zugrunde liegend Erfindungsgedanke verlassen wird.

### Bezugszeichenliste

- 1: Metall-Keramik-Substrat
- 2: Keramikschicht
- 2': freier Rand
- 2.1: Oberseite
- 2.2: Unterseite
- 3: erste Metallisierung
- 4: zweite Metallisierung
- 5: erste Metallschicht
- 5': weitere Metallschicht
- 5a: freier Randabschnitt
- 5b: Randbereich
- 6: zweite Metallschicht
- 6': weitere Metallschicht
- 6a: freier Randabschnitt
- 6b: Randbereich
- 7: Metallbehälter
- 7.1, 7.2: Behälterhälften
- 8: Behälterinneren
- 9: Hilfswerkzeug
- 9.1, 9.2: Halbschalen
- 11: poröses Material
- 12: gasdichte Versiegelungsschicht
- 13: umlaufende, rahmenartige Lotschicht
- 14: randseitige Lotverbindung
- 15, 15': schlitzartige Zwischenraum

- VB, VB': ringförmiger Verbindungsbereich
- F, F': Spannkräfte

## Patentansprüche

1. Verfahren zur Herstellung eines Metall-Keramik-Substrates (1) umfassend eine erste und zweite Metallisierung (3, 4) und zumindest eine zwischen der ersten und zweiten Metallisierung (3, 4) aufgenommene Keramikschicht (2),
**dadurch gekennzeichnet,**
**dass** eine erste und zweite Metallschicht (5, 6) und die Keramikschicht (2) übereinander gestapelt werden, und zwar derart, dass die freien Randabschnitte (5a, 6a) der ersten und zweiten Metallschicht (5, 6) jeweils randseitig über die Keramikschicht (2) überstehen,
**dass** zur Bildung eines gasdicht verschlossenen, einen Behälterinnenraum (8) einschließenden Metallbehälters (7) zur Aufnahme der Keramikschicht (2) die ersten und zweiten Metallschichten (5, 6) im Bereich der überstehenden freien Randabschnitte (5a, 6a) zueinander verformt und direkt miteinander verbunden werden,
**dass** die den Metallbehälter (7) bildenden Metallschichten (5, 6) mit der im Behälterinneren aufgenommener Keramikschicht (2) in einer Behandlungskammer bei einem Gasdruck zwischen 500 und 2000 bar und einer Prozesstemperatur zwischen 300°C bis zur Schmelztemperatur der Metallschichten (5, 6) zur Herstellung einer flächigen Verbindung zumindest einer der Metallschichten (5, 6) und der Keramikschicht (2) heißisostatisch miteinander verpresst werden, wobei zumindest die überstehenden, miteinander verbundenen freien Randabschnitte (5a, 6a) der Metallschicht (5, 6) nach dem heißisostatischen Verpressen der Metallschichten (5,6) mit der Keramikschicht (2) zur Bildung der ersten und zweiten Metallisierung (3, 4) entfernt werden.

2. Verfahren nach Anspruch 1, **dadurch gekennzeichnet, dass** zur Bildung des Metallbehälters (7) die freien Randabschnitte (5a, 6a) der Metallschichten (5, 6) vor deren direkten Verbindung durch Beaufschlagen mit einer Spannkraft (F, F') verformt werden.

3. Verfahren nach Anspruch 1 oder 2, **dadurch gekennzeichnet, dass** die freien Randabschnitte (5a, 6a) der Metallschichten (5, 6) randseitig durch Schweißen, insbesondere Kontaktschweißen oder Laserschweißen oder durch Löten, auch Hartlöten miteinander verbunden werden oder dass die randseitige direkte Verbindung der Metallschichten (5, 6) mittels eines mechanischen Verbindungs- und/oder Bearbeitungsverfahren hergestellt wird, und zwar durch Walzen, Verpressen und/oder Umbördeln der freien Randabschnitte (5a, 6a).

4. Verfahren nach einem der Ansprüche 1 bis 3, **dadurch gekennzeichnet, dass** der Behälterinnenraum (8) vor dem randseitigen direkten Verbinden der Metallschichten (5, 6) vakuumiert wird.

5. Verfahren nach Anspruch 4, **dadurch gekennzeichnet, dass** in den vakuumierten Behälterinnenraum (8) vor dem randseitigen direkten Verbinden der Metallschichten (5, 6) Sauerstoff eingebracht wird oder dass die Metallschichten (5, 6) im Vakuum oder in einer Inertgasatmosphäre, vorzugsweise unter Verwendung von Stickstoff oder Argons als Inertgas randseitig direkt miteinander verbunden werden.

6. Verfahren nach einem der Ansprüche 1 bis 5, **dadurch gekennzeichnet, dass** zusätzlich zu der Keramikschicht (2) in den Behälterinnenraum (8) ein poröses Material (11), vorzugsweise Metall oder Keramik eingebracht wird, das zur Aufnahme eines im Behälterinnenraum (8) vorhandenen Restgases ausgebildet ist.

7. Verfahren nach Anspruch 6, **dadurch gekennzeichnet, dass** das poröse Material (11) vor dem Einbringen in den Behälterinnenraum (8) vakuumiert und mit einer gasdichten Versiegelungsschicht (12) beschichtet wird oder dass das poröse Material (11) vor dem Einbringen in den Behälterinnenraum (8) mit Sauerstoff aufgeladen und mit einer gasdichten Versiegelungsschicht (12) beschichtet wird.

8. Verfahren nach einem der Ansprüche 1 bis 7, **dadurch gekennzeichnet, dass** die Keramikschicht (2) an ihrer Ober- und/oder Unterseite (2.1, 2.2) vor dem Stapeln vollflächig mit einer Hartlotschicht bzw. einer Aktivlotschicht beschichtet wird und/oder dass die erste und/oder zweite Metallisierung (3, 4) aus Kupfer oder einer Kupferlegierung und/oder Aluminium oder einer Aluminiumlegierung hergestellt werden.

9. Verfahren nach einem der Ansprüche 1 bis 8, **dadurch gekennzeichnet, dass** die Keramikschicht (2) aus einer Oxid-, Nitrid- oder Karbidkeramik, und zwar Aluminiumoxid (Al2O3) oder Aluminiumnitrid (AIN) oder Siliziumnitrid (Si3N4) oder Siliziumkarbid (SiC) oder aus Aluminiumoxid mit Zirkonoxid (Al2O3 +ZrO2) hergestellt wird.

10. Verfahren zur Herstellung eines Metall-Keramik-Substrates (1) umfassend eine erste und zweite Metallisierung (3, 4) und zumindest eine zwischen der ersten und zweiten Metallisierung (3, 4) aufgenommene Keramikschicht (2) mit einer Ober- und Unterseite (2.1, 2.2),
**dadurch gekennzeichnet,**
**dass** auf die Ober- und/oder Unterseite (2.1, 2.2) der Keramikschicht (2) randseitig eine umlaufende, rahmenartige, vorzugsweise kontinuierliche Lotschicht (13) aufgebracht wird,
**dass** eine erste und zweite Metallschicht (5, 6) und die Keramikschicht (2) übereinander gestapelt werden und durch Erhitzen zumindest im Bereich der umlaufenden, rahmenartigen Lotschicht (13) eine randseitige Lotverbindung (14) erzeugt wird, und zwar derart, dass zwischen der Keramikschicht (2) und zumindest einer der Metallschichten (5, 6) ein gasdicht abgeschlossener, spaltartiger Zwischenraum (15, 15') entsteht,
**dass** die Metallschichten (5, 6) und die Keramikschicht (2) in einer Behandlungskammer bei einem Gasdruck zwischen 500 und 2000 bar und einer Prozesstemperatur zwischen 300°C bis zur Schmelztemperatur der Metallschichten (5, 6) oder der Lotschicht (13) zur Herstellung einer flächigen Verbindung zumindest einer der Metallschichten (5, 6) und der Keramikschicht (2) heißisostatisch miteinander verpresst werden, wobei die Metallschichten (5, 6) die Metallisierungen (3, 4) bilden.

11. Verfahren nach Anspruch 10, **dadurch gekennzeichnet, dass** zumindest die über die randseitige Lotverbindung (14) mit der Keramikschicht (2) verbundenen Randbereiche (5b, 6b) der Metallschichten (5, 6) zur Bildung der ersten und zweiten Metallisierung (3, 4) entfernt werden.

12. Verfahren nach einem der vorhergehenden Ansprüche, **dadurch gekennzeichnet, dass** eine der Metallschichten (5, 6) vor dem heißisostatischen Verpressen unter Verwendung eines Direct-Copper-Bonding-Verfahrens oder eines Hartlot- bzw. Aktivlotverfahrens mit der Keramikschicht (2) verbunden wird.

13. Verfahren nach einem der vorhergehenden Ansprüche, **dadurch gekennzeichnet, dass** zwischen der ersten Metallschicht (5) und der Keramikschicht (2) und/oder zwischen der zweiten Metallschicht (6) und der Keramikschicht (2) zumindest eine weitere Metallschicht (5', 6'), vorzugsweise aus Kupfer oder Aluminium beim Stapeln eingebracht wird.

14. Verfahren nach einem der vorhergehenden Ansprüche, **dadurch gekennzeichnet, dass** die Schichten (2, 5, 6) mittels eines Hilfswerkzeuges (9) umfassend zwei Halbschalen (9.1, 9.2) zum randseitigen Verbinden der Metallschichten (5, 6) gegeneinander verspannt werden.

15. Verfahren nach einem der vorhergehenden Ansprüche, **dadurch gekennzeichnet, dass** zumindest eine der Metallschichten (5, 6) und/oder die Ober- und/oder Unterseite (2.1, 2.2) der Keramikschicht (2) vor dem Stapeln mit einer Oxidschicht versehen werden.

## Claims

1. A process for manufacturing a metal-ceramic substrate (1) comprising a first and a second metallization (3, 4) and at least one ceramic layer (2) received between the first and second metallization (3, 4),
**characterized in that**
a first and second metal layer (5, 6) and the ceramic layer (2) are stacked on top of each other such that the free edge portions (5a, 6a) of the first and second metal layers (5, 6) each project over the ceramic layer (2) on the edge side,
**in that**, in order to form a metal container (7), which is closed in a gastight manner and encloses a container interior (8), for receiving the ceramic layer (2), the first and second metal layers (5, 6) are deformed in relation to each other in the region of the protruding free edge portions (5a, 6a) and are directly connected to each other,
**in that** the metal layers (5, 6) forming the metal container (7) are hot-isostatically pressed with the ceramic layer (2) received in the container interior in a treatment chamber at a gas pressure between 500 and 2000 bar and a process temperature between 300°C up to the melting temperature of the metal layers (5, 6) for producing a laminar connection of at least one of the metal layers (5, 6) and the ceramic layer (2), at least the projecting, interconnected free edge portions (5a, 6a) of the metal layer (5, g) being removed after hot-isostatically pressing of the metal layers (5, 6) with the ceramic layer (2) to form the first and second metallization (3, 4).

2. The process according to claim 1, **characterized in that** in order to form the metal container (7), the free edge portions (5a, 6a) of the metal layers (5, 6) are deformed by applying a clamping force (F, F') before direct connection thereof.

3. The process according to Claim 1 or 2, **characterized in that** the free edge portions (5a, 6a) of the metal layers (5, 6) are also joined to each other on the edge side by welding, especially contact welding or laser welding or by soldering, or **in that** the direct connection of the metal layers (5, 6) on the edge side is produced by means of a mechanical joining and/or processing process, and is produced by rolling, pressing and/or flanging the free edge portions (5a, 6a).

4. The process according to one of claims 1 to 3, **characterized in that** the container interior (8) is vacuumed before the direct connection of the metal layers (5, 6) at the edge.

5. The process according to claim 4, **characterized in that** oxygen is introduced into the vacuumed container interior (8) before the metal layers (5, 6) are directly bonded at the edge or **in that** the metal layers (5, 6) are bonded directly to each other at the edge in a vacuum or in an inert gas atmosphere, preferably using nitrogen or argon as an inert gas.

6. The process according to one of claims 1 to 5, **characterized in that**, in addition to the ceramic layer (2), a porous material (11), preferably metal or ceramics, is introduced into the container interior (8), which is designed to contain a residual gas present in the container interior (8).

7. The process according to claim 6, **characterized in that** the porous material (11) is vacuumed and coated with a gas-tight sealing layer (12) before being introduced into the container interior (8), or **in that** the porous material (11) is charged with oxygen before being introduced into the container interior (8) and coated with a gas-tight sealing layer (12).

8. The process according to one of claims 1 to 7, **characterized in that** the ceramic layer (2) on its upper side and/or lower side (2.1, 2.2) is coated with a hard solder layer or an active solder layer across its entire surface before stacking and/or **in that** the first and/or second metallization (3, 4) is produced from copper or a copper alloy and/or aluminum or an aluminum alloy.

9. The process according to any of Claims 1 to 8, **characterized in that** the ceramic layer (2) is manufactured of an oxide, nitride or carbide ceramics, and is manufactured of an aluminum oxide (Al₂O₃) or aluminum nitride (AIN) or silicon nitride (Si₃N₄) or silicon carbide (SiC) or of aluminum oxide with zirconium oxide (Al₂O₃ + ZrO₂).

10. A process for producing a metal-ceramic substrate (1) comprising a first and a second metallization (3, 4) and at least one ceramic layer (2) having an upper and lower side (2.1, 2.2) received between the first and second metallization (3, 4),
**characterized in that,**
a circumferential frame-like preferably continuous solder layer (13) is applied onto the upper and/or lower side (2.1, 2.2) of the ceramic layer (2) at the edge,
**in that** a first and second metal layer (5, 6) and the ceramic layer (2) are stacked on top of each other and an edge-side solder connection (14) is produced by heating at least in the region of the surrounding frame-like solder layer (13), such that a gap-like space (15, 15') is formed between the ceramic layer (2) and at least one of the metal layers (5, 6) in a gas-tight manner,
**in that** the metal layers (5, 6) and the ceramic layer (2) are hot-isostatically pressed together in a treatment chamber at a gas pressure between 500 and 2000 bar and a process temperature between 300°C up to the melting temperature of the metal layers (5, 6) or the solder layer (13) to produce a laminar connection of at least one of the metal layers (5, 6) and the ceramic layer (2), the metal layers (5, 6) forming the metalizations (3, 4).

11. The process according to claim 10, **characterized in that** at least the edge regions (5b, 6b) of the metal layers (5, 6) connected to the ceramic layer (2) via the edge-side solder connection (14) are removed to form the first and second metallization (3, 4).

12. The process according to one of the preceding claims, **characterized in that** one of the metal layers (5, 6) is bonded to the ceramic layer (2) prior to hot-isostatic pressing using a direct-copper-bonding process or a hard solder or active solder process.

13. The process according to one of the preceding claims, **characterized in that** between the first metal layer (5) and the ceramic layer (2) and/or between the second metal layer (6) and the ceramic layer (2) at least another metal layer (5', 6'), preferably of copper or aluminum, is introduced during stacking.

14. The process according to one of the preceding claims, **characterized in that** the layers (2, 5, 6) are clamped against each other by means of an auxiliary tool (9) comprising two half-shells (9.1, 9.2) for edge-side joining the metal layers (5, 6).

15. The process according to one of the preceding claims, **characterized in that** at least one of the metal layers (5, 6) and/or the upper and/or lower side (2.1, 2.2) of the ceramic layer (2) is provided with an oxide layer before stacking.

## Revendications

1. Procédé de fabrication d'un substrat métal/céramique (1), comportant une première et une seconde métallisation (3, 4) et au moins une couche céramique (2) reçue entre la première et la seconde métallisation (3, 4),
**caractérisé en ce que**
une première et une seconde couche métallique (5, 6) et la couche céramique (2) sont empilées les unes au-dessus des autres, et ceci de telle sorte que les portions de bord libres (5a, 6a) de la première et de la seconde couche métallique (5, 6) dépassent chacune du côté bord au-delà de la couche céramique (2),
pour former un récipient métallique (7) fermé de façon étanche aux gaz et enfermant un volume intérieur (8) du récipient et destiné à recevoir la couche céramique (2), les premières et les secondes couches métalliques (5, 6) sont déformées et reliées directement l'une à l'autre au niveau des portions de bord libres (5a, 6a) en dépassement,
les couches métalliques (5, 6) formant le récipient métallique (7) sont pressées ensemble par voie isostatique à chaud avec la couche céramique (2) reçue dans l'intérieur du récipient, dans une chambre de traitement à une pression de gaz entre 500 et 2000 bar et à une température de traitement entre 300 °C et la température de fusion des couches métalliques (5, 6) pour établir une liaison surfacique de l'une au moins des couches métalliques (5, 6) et de la couche céramique (2), et au moins les portions de bord libres (5a, 6a) en dépassement reliées l'une à l'autre de la couche métallique (5, 6) sont enlevées après le pressage isostatique à chaud des couches métalliques (5, 6) avec la couche céramique (2) pour former la première et la seconde métallisation (3, 4).

2. Procédé selon la revendication 1, **caractérisé en ce que** pour former le récipient métallique (7), les portions de bord libres (5a, 6a) des couches métalliques (5, 6) sont déformées en les sollicitant par une force de serrage (F, F'), avant de les relier directement.

3. Procédé selon la revendication 1 ou 2, **caractérisé en ce que** les portions de bord libres (5a, 6a) des couches métalliques sont reliées l'une à l'autre du côté bord par soudage, en particulier par soudage par contact ou par soudage laser ou par brasage, également par brasage fort, ou **en ce que** la liaison directe du côté bord des couches métalliques (5, 6) est établie au moyen d'une procédure de jonction et/ou de transformation mécanique, à savoir par laminage, par pressage et/ou par rabattement des portions de bord libres (5a, 6a).

4. Procédé selon l'une des revendications 1 à 3, **caractérisé en ce que** le volume intérieur (8) du récipient est mis sous vide avant de relier directement les couches métalliques (5, 6) du côté bord.

5. Procédé selon la revendication 4, **caractérisé en ce qu'**avant de relier directement les couches métalliques (5, 6) du côté bord, de l'oxygène est introduit dans le volume intérieur (8) du récipient mis sous vide, ou **en ce que** les couches métalliques (5, 6) sont reliées directement l'une à l'autre du côté bord, sous vide ou dans une atmosphère de gaz inerte, de préférence en utilisant de l'azote ou de l'argon à titre de gaz inerte.

6. Procédé selon l'une des revendications 1 à 5, **caractérisé en ce qu'**en supplément à la couche céramique (2), un matériau poreux (11), de préférence du métal ou de la céramique, est introduit dans le volume intérieur (8) du récipient, matériau qui est réalisé pour recevoir un gaz résiduel présent dans le volume intérieur (8) du récipient.

7. Procédé selon la revendication 6, **caractérisé en ce que** le matériau poreux (11) est mis sous vide avant de l'introduire dans le volume intérieur (8) du récipient et il est revêtu d'une couche de scellement (12) étanche aux gaz, ou le matériau poreux (11) est chargé d'oxygène, avant de l'introduire dans le volume intérieur (8) du récipient, et il est revêtu d'une couche de scellement (12) étanche aux gaz.

8. Procédé selon l'une des revendications 1 à 7, **caractérisé en ce qu'**avant l'empilement, la couche céramique (2) est revêtue sur toute la surface d'une couche d'apport de brasage fort ou d'une couche d'apport de brasage actif sur sa face supérieure et/ou inférieure (2.1, 2.2), et/ou **en ce que** la première et/ou la seconde métallisation (3, 4) sont réalisées en cuivre ou en un alliage de cuivre et/ou en aluminium ou en un alliage d'aluminium.

9. Procédé selon l'une des revendications 1 à 8, **caractérisé en ce que** la couche céramique (2) est réalisée en une céramique à base d'oxyde, de nitrure ou de carbure, à savoir d'alumine (Al2O3) ou de nitrure d'aluminium (AlN) ou de nitrure de silicium (Si3N4) ou de carbure de silicium (SiC), ou bien en alumine avec de l'oxyde de zirconium (Al2O3 + ZrO2).

10. Procédé de fabrication d'un substrat métal/céramique (1), comportant une première et une seconde métallisation (3, 4) et au moins une couche céramique (2) reçue entre la première et la seconde métallisation (3, 4) et présentant une face supérieure et une face inférieure (2.1, 2.2),
**caractérisé en ce que**
sur la face supérieure et/ou inférieure (2.1, 2.2) de la couche céramique (2) est appliquée, du côté bord, une couche d'apport de brasage (113) périphérique, en forme de cadre, de préférence continue,
une première et une seconde couche métallique (5, 6) et la couche céramique (2) sont empilées les unes au-dessus des autres, et une jonction brasée (14) côté bord est réalisée par chauffage au moins au niveau de la couche d'apport de brasage (13) périphérique en forme de cadre, et ceci de telle sorte qu'un espace intermédiaire (15, 15') en forme d'intervalle et fermé de façon étanche aux gaz résulte entre la couche céramique (2) et l'une au moins des couches métalliques (5, 6),
les couches métalliques (5, 6) et la couche céramique (2) sont pressées ensemble par voie isostatique à chaud, dans une chambre de traitement à une pression de gaz entre 500 et 2000 bar et à une température de traitement entre 300 °C et la température de fusion des couches métalliques (5, 6) ou de la couche d'apport de brasage (13) pour établir une liaison surfacique de l'une au moins des couches métalliques (5, 6) et de la couche céramique (2), les couches métalliques (5, 6) formant les métallisations (3, 4).

11. Procédé selon la revendication 10, **caractérisé en ce qu'**au moins les zones de bord (5b, 6b) des couches métalliques (5, 6) reliées à la couche céramique (2) par la jonction brasée (14) côté bord sont enlevées pour former la première et la seconde métallisation (3, 4).

12. Procédé selon l'une des revendications précédentes, **caractérisé en ce qu'**avant le pressage isostatique à chaud, une des couches métalliques (5, 6) est reliée à la couche céramique (2) en utilisant un procédé de métallisation directe au cuivre (Direct-Copper-Bonding) ou un procédé de brasage fort ou actif.

13. Procédé selon l'une des revendications précédentes, **caractérisé en ce que** lors de l'empilement, au moins une autre couche métallique (5', 6'), de préférence en cuivre ou en aluminium, est introduite entre la première couche métallique (5) et la couche céramique (2) et/ou entre la seconde couche métallique (6) et la couche céramique (2).

14. Procédé selon l'une des revendications précédentes, **caractérisé en ce que** pour relier les couches métalliques (5, 6) du côté bord, les couches (2, 5, 6) sont serrées les unes contre les autres au moyen d'un outil accessoire (9) comportant deux demi-coques (9.1, 9.2).

15. Procédé selon l'une des revendications précédentes, **caractérisé en ce qu'**avant l'empilement, l'une au moins des couches métalliques (5, 6) et/ou la face supérieure et/ou inférieure (2.1, 2.2) de la couche céramique (2) sont pourvues d'une couche d'oxyde.
